# FASCICULE DE BREVET EUROPEEN

(11) **EP 0 434 495 B1**
(45) Date de publication et mention de la délivrance du brevet: **16.08.1995**
(21) Numéro de dépôt: 90403494.9
(22) Date de dépôt: 07.12.1990
(51) Int. Cl.: G11C 7/00

(54) **Circuit de précharge d'un bus de mémoire**
Vorladeschaltung für Speicherbus
Memory bus precharge circuit

(30) Priorité: 21.12.1989 FR 8916954
(43) Date de publication de la demande: 26.06.1991
(73) Titulaire: BULL S.A., 92800 Puteaux (FR)
(72) Inventeur: Brossard, Patrice, F-75764 Paris Cédex 16 (FR)
(74) Mandataire: Denis, Hervé

(56) Documents cités:
- GB-A- 2 028 044
- GB-A- 2 070 372
- US-A- 4 813 020
- US-A- 4 873 673

## Description

L'invention se rapporte à un circuit de précharge d'un bus de mémoire intégrée. Elle s'applique à toutes sortes de mémoires, et plus particulièrement aux mémoires intégrées dans des plaquettes semiconductrices incorporant des transistors bipolaires et des transistors à effet de champ. Elle est bien adaptée aux transistors à effet de champ de type MOS (Metal Oxide Semiconductor) de même type ou de types complémentaires. La description qui suit se réfère à titre d'exemple illustratif à la technologie BiCMOS (Bipolar Complementary MOS).

La lecture et l'écriture dans une cellule de mémoire se font généralement par l'intermédiaire d'un ou deux bus durant des phases de lecture ou d'écriture incluses dans un signal d'horloge. Actuellement, il est courant de faire précéder la phase d'écriture et/ou la phase de lecture par une phase de précharge du ou des bus. Les phases de précharge sont incorporées dans le signal d'horloge. Un seul bus sera pris en considération pour des raisons de commodité. Le but de la précharge est de mettre le bus à un potentiel prédéterminé couramment égal à un potentiel d'alimentation. L'écriture et la lecture se font par le maintien de la tension prédéterminée du bus ou par la décharge du bus selon l'état binaire à écrire dans une cellule de mémoire ou lu d'une cellule. La précharge se fait ordinairement par au moins un transistor à effet de champ quand le bus a une faible valeur capacitive. Cependant, la précharge rapide d'un bus ayant une valeur capacitive relativement élevée, par exemple supérieure à 1 pF, requiert l'emploi d'un transistor bipolaire. Ce transistor a son collecteur connecté au potentiel haut d'alimentation Vcc et son émetteur connecté au bus. Sa base est connectée au Vcc et à la masse par l'intermédiaire des trajets drain-source respectifs de deux transistors MOS de types complémentaires recevant sur leurs grilles le signal d'horloge. En dehors de la phase de précharge, le transistor MOS connecté à la masse conduit pour assurer la décharge de la base du transistor bipolaire. La phase de précharge bloque ce transistor et fait conduire l'autre transistor MOS. Ce transistor MOS crée un trajet de courant issu du potentiel d'alimentation Vcc pour commander la conduction du transistor bipolaire. La fin de la phase de précharge du signal d'horloge coupe le trajet de courant et commande la conduction de l'autre transistor MOS pour décharger la base du transistor bipolaire.

Ce circuit de précharge présente plusieurs inconvénients. La précharge du bus faite par ce circuit s'arrête normalement lorsque la tension de précharge s'approche suffisamment de la tension d'alimention Vcc pour couper ou rendre peu conducteur le transistor bipolaire. Dans ces conditions, la durée de précharge dépend principalement de la valeur capacitive du bus et de la capacité de conduction du transistor MOS piloté par le signal d'horloge pour alimenter la base du transistor bipolaire. Il est bien connu qu'un transistor à effet de champ présente une grande dispersion de ses caractéristiques courant/tension en fonction des conditions de la fabrication, allant jusqu'à un rapport supérieur à 3. Il s'ensuit qu'un circuit de précharge de l'art antérieur ne permet aucun ajustement de la tension de précharge et que la commande de cette tension par la durée du signal d'horloge ne peut être efficace à cause de la grande dispersion des caractéristiques du transistor à effet de champ commandant la conduction du trajet de courant d'alimentation de la base du transistor bipolaire.

On connaît aussi du document US-A-4873673 un circuit de précharge d'un bus de mémoire, comprenant un transistor à effet de champ piloté par un signal d'horloge et reliant le bus à un potentiel d'alimentation. L'électrode de commande de ce transistor est reliée aux deux potentiels d'alimentation par l'intermédiaire de deux transistors respectifs à effet de champ de types complémentaires ayant leurs grilles reliées à la sortie d'un amplificateur à seuil connecté au bus. D'autre part, il est connu du document US-A-4813020 un circuit combinant des transistors à effet de champ avec un transistor bipolaire, destiné à passer un fort courant et qui permettrait ainsi de charger rapidement un bus ayant une valeur capacitive élevée. Cependant, la combinaison de ces deux documents ne peut remédier aux inconvénients du circuit de précharge décrit dans le premier document cité.

L'invention remédie à ces inconvénients, grâce à un circuit de précharge permettant l'ajustement de la tension de précharge d'un bus de mémoire à une valeur prédéterminée pendant la phase de précharge du signal d'horloge.

Selon l'invention, un circuit de précharge d'un bus de mémoire a les caractéristiques définies par la revendication 1.

Les caractéristiques et avantages de l'invention ressortiront de la description qui suit, donnée à titre d'exemple et faite en référence à la figure des dessins annexés.

Dans les dessins :
- la figure 1 illustre un exemple de réalisation d'un circuit de précharge conforme à l'invention ; et
- la figure 2 présente diverses formes d'ondes illustrant le fonctionnement du circuit de précharge représenté sur la figure 1.

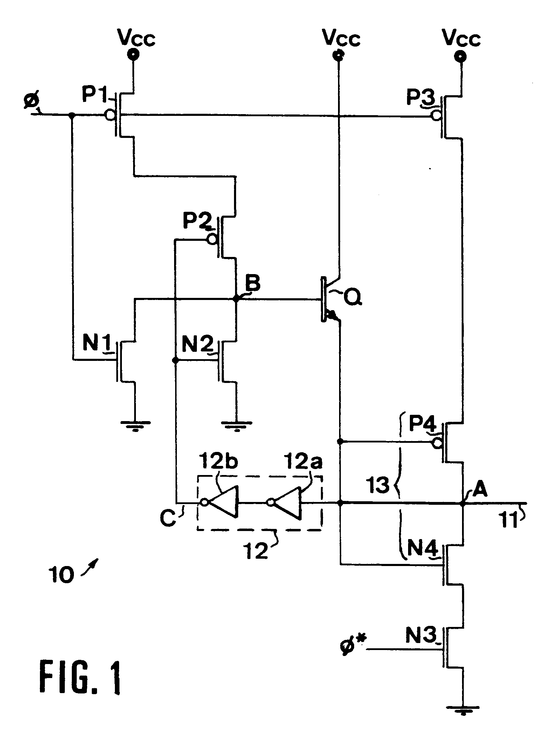

Dans la figure 1, le circuit de précharge 10 d'un bus de mémoire 11 inclut un transistor bipolaire Q piloté par un signal d'horloge φ. Le circuit de précharge 10 est fait en technologie BiCMOS. Les transistors n-MOS sont désignés par N et les transistors p-MOS par P. Dans le circuit de précharge 10, le transistor bipolaire Q a son émetteur connecté au bus 11 en un point A et son collecteur connecté au potentiel d'alimentation Vcc. Sa base constitue le point B du circuit de précharge 10. Le signal d'horloge φ est appliqué sur les grilles de deux transistors N1, P1. Le drain du transistor P1 est connecté au potentiel d'alimentation Vcc et sa source est reliée au point B. La source du transistor N1 est à la masse et son drain est connecté au point B.

Selon l'invention, la base B du transistor bipolaire Q est reliée respectivement au potentiel d'alimentation Vcc et à la masse par l'intermédiaire de deux transistors P2, N2 ayant leurs grilles reliées à la sortie C d'un amplificateur à seuil 12 connecté au bus 11. En d'autres termes, les trajets drain-source des transistors P1 et P2 sont montés en série entre la base B du transistor bipolaire Q et le potentiel d'alimentation Vcc, tandis que les trajets drain-source des transistors N1 et N2 sont montés en parallèle entre la base B du transistor bipolaire Q et la masse. L'amplificateur à seuil 12 se compose de deux inverseurs 12a, 12b. L'inverseur 12a a son entrée connectée au point A du bus 11 et présentant un seuil Ta. L'inverseur 12b a son entrée connectée à la sortie de l'inverseur 12a et présentant un seuil Tb.

Le circuit de précharge 10 inclut en outre quatre transistors N3, P3, N4, P4 ayant leurs trajets drain-source montés en série entre le potentiel d'alimentation Vcc et la masse. Le transistor P3 a sa source connectée au potentiel Vcc et sa grille recevant le signal d'horloge φ. Le transistor N3 a sa source connectée à la masse et sa grille recevant le signal d'horloge complémentaire φ*. Les drains des transistors P4 et N4 sont réunis au point A du bus 11. Leurs grilles sont communes et réunies aussi au point A du bus 11, de sorte que les transistors N4 et P4 constituent des diodes. Leurs courbes caractéristiques courant/tension se rapportent à des axes des abscisses communs (tension), ayant repectivement pour origines les points de tension 0 volt et V_{CC}. Les deux courbes caractéristiques des deux diodes se coupent en un point dont l'abscisse détermine la tension au point A. La dimensionnement des transistors N4 et P4 l'un par rapport à l'autre est déterminé pour conférer au point A le potentiel de précharge Vp désiré du bus 11. Les transistors N4 et P4 forment ainsi un circuit de polarisation 13.

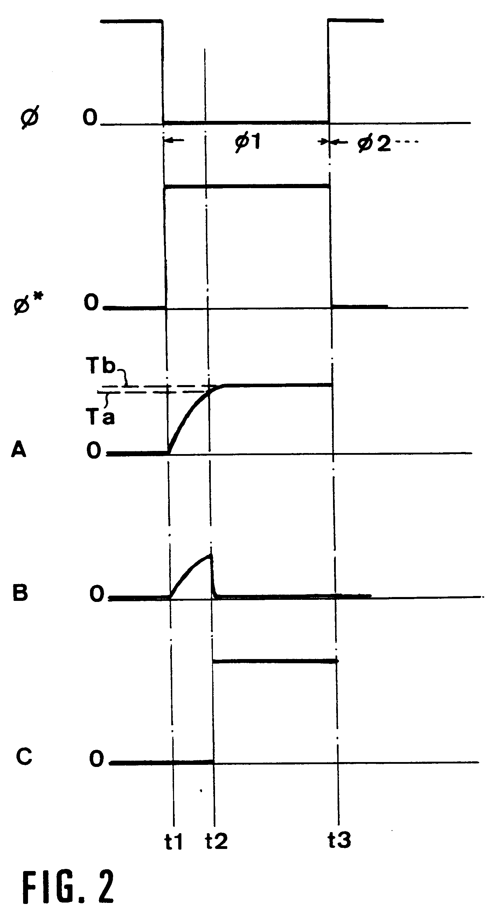

Le fonctionnement du circuit de précharge 10 va maintenant être décrit en référence au chronogramme de la figure 2 illustrant des formes d'ondes des signaux d'horloge φ et φ* et des signaux aux point A, B et C du circuit de précharge 10. Dans l'exemple illustré, le signal d'horloge φ inclut une phase de précharge φ1 et une phase d'exécution (écriture ou lecture) φ2. La phase de précharge débute à l'instant t1. Avant l'instant t1, le signal d'horloge φ a l'état logique 1. On supposera que l'état logique 1 correspond au potentiel d'alimentation Vcc = +5 volts. L'application du signal d'horloge φ au circuit de précharge 10 bloque dont les transistors P1 et P3 et met le transistor N1 en état de conduction. Le blocage du transistor P1 empêche la conduction du transistor bipolaire Q. L'état de conduction du transistor N1 assure l'évacuation vers la masse des charges accumulées sur la base du transistor bipolaire Q. Par conséquent, le potentiel au point B est 0 volt. On suppose d'autre part que le potentiel au point A du bus 11 à l'état initial est 0 volt. Ce potentiel est transmis par l'amplificateur 12 au point C, de sorte que le transistor N2 est bloqué et le transistor P2 est en état de conduction. Cependant, il ne peut pas conduire de courant à cause du blocage de P1.

A l'instant t1, le signal d'horloge φ prend l'état logique 0 correspondant à la phase de précharge φ1. L'application du signal d'horloge φ au circuit de précharge 10 à l'instant t1 met en état du conduction les transistors P1 et P3 et bloque le transistor N1. La conduction des transistors P1 et P2 et le blocage des transistors N1 et N2 permettent l'injection d'un courant important dans la base du transistor bipolaire Q. La forte conduction du transistor bipolaire Q élève rapidement le potentiel du point A du bus 11. On supposera que la tension de précharge désirée Vp du bus 11 soit égale à 2,5 volts. Dans ces conditions, on donnera avantageusement au seuil Ta de l'inverseur 12a de l'amplificateur 12 une valeur légèrement inférieure à Vp, soit 2,3 volts, par exemple. Le seuil Tb de l'inverseur 12b sera supérieur au seul Ta, de préférence égal à Vp. Dans ces conditions, le point C demeure à 0 volt. D'autre part, à l'instant t1 les transistors P3 et N3 deviennent conducteurs. Par conséquent un courant passant par les transistors P3 et P4 charge ainsi le bus 11. Cependant, la charge du bus à travers ces transistors est sensiblement plus lente que celle faite à travers le transistor Q. A l'instant t2, le potentiel du point A atteint la valeur de seuil Ta = 2,3 volts. A cette valeur, la sortie de l'inverseur 12a reprend l'état "0". Le potentiel au point C bascule donc à + 5 volts, de sorte que le transistor P2 se bloque et le transistor N2 conduit. La conduction du transistor bipolaire Q est donc interrompue brusquement à l'instant t2. Le circuit de polarisation 13 continue de charger lentement le bus 11. Le dimensionnement des transistors N4, P4 montées en diodes est déterminé pour que la tension au point A soit stabilisée à la tension de précharge désirée Vp = 2,5 volts. Le circuit de polarisation 13 empêche aussi les oscillations parasites que pourrait produire l'arrêt brutal de la conduction du transistor bipolaire Q. Le potentiel du point A est donc stabilisé à la tension de précharge désirée Vp peu de temps après l'instant t2, jusqu'à la fin de la phase de précharge à l'instant t3. A cet instant débute la phase de lecture ou d'écriture φ2, correspondant à l'état logique 1 du signal d'horloge φ. Dans ces conditions, les transistors P1, P3 et N3 se bloquent et permettent le maintien ou la décharge du bus 11 selon l'état logique correspondant au bus 11 durant la phase d'écriture ou de lecture.

Il est à noter que la conduction du transistor N2 entre les instants t2 et t3 contribue à décharger la base du transistor bipolaire Q pendant sa période d'interruption. Le transistor N1 pourrait donc être supprimé. Son maintien peut se justifier seulement pour des raisons de décharge électrostatique en dehors de la phase de précharge φ1. Par ailleurs, il est clair que le circuit de polarisation 13 peut avoir une autre forme que celle décrite, constituée du diviseur de tension N4, P4.

D'autre part, il est important que les grilles des transistors N2 et P2 soient connectées à la sortie C de l'amplificateur 12. Si par exemple la grille du transistor N2 était connectée au point A, l'élévation progressive du potentiel en ce point à partir de l'instant t1 rendrait de plus en plus conducteur le transistor N2. Par conséquent, une partie de plus en plus grande du courant traversant les transistors P1 et P2 serait détournée vers la masse, de sorte que le transistor Q deviendrait de moins en moins conducteur. Il en résulterait une durée de précharge t2-t1 beaucoup plus longue. Un montage additionnel complexe serait nécessaire pour réduire cette durée. Le dispositif de précharge conforme à l'invention offre l'avantage d'être très simple et d'obtenir une durée de précharge très brève.

Il est à noter que la présence des quatre transistors N3, P3 et N4, P4 n'est pas nécessaire. En leur absence, le seuil Ta pourrait être ajusté sur la tension de précharge désirée Vp. Les quatre transistors additionnels offrent l'avantage d'assurer une bonne stabilité du fonctionnement du circuit de précharge 10 et de la tension de précharge Vp.

## Revendications

1. Circuit de précharge (10) d'un bus de mémoire (11), comprenant un transistor (Q) piloté par un signal d'horloge (φ) et reliant le bus à un potentiel d'alimentation, et dont l'électrode de commande (B) est reliée aux deux potentiels d'alimentation par l'intermédiaire de deux transistors respectifs à effet de champ de types complémentaires (N2, P2) ayant leurs grilles reliées à la sortie d'un amplificateur à seuil (12) connecté au bus, caractérisé en ce que ledit transistor (Q) est de type bipolaire et est piloté par le signal d'horloge (φ) par l'intermédiaire d'un troisième transistor à effet de champ (P1) ayant son trajet drain-source monté en série avec celui de l'un (P2) des deux transistors à effet de champ.

2. Circuit selon la revendication 1, caractérisé en ce que la valeur de seuil (Ta) de l'amplificateur (12) est légèrement inférieure à la tension de précharge désirée (Vp) du bus (11).

3. Circuit de précharge selon la revendication 1 ou 2, caractérisé en ce que le signal d'horloge commande la conduction d'un quatrième transistor à effet de champ (N1) ayant son trajet drain-source monté en parallèle avec celui de l'autre transistor (N2) des deux transistors à effet de champ précités.

4. Circuit selon l'une des revendications 1 à 3, caractérisé en ce que le bus (11) est connecté à un circuit de polarisation (13) commandé par le signal d'horloge et ajusté sur la tension de précharge désirée (Vp) du bus (11).

5. Circuit selon la revendication 4, caractérisé en ce que le circuit de polarisation (13) inclut un diviseur de tension (N4, P4) fournissant une tension de polarisation ajustée sur la tension de précharge désirée (Vp) du bus (11).

6. Circuit selon la revendication 4 ou 5, caractérisé en ce que le circuit de polarisation (13) inclut deux transistors à effet de champ de types complémentaires (N4, P4) montés en diodes et dimensionnés l'un par rapport à l'autre pour ajuster la tension de polarisation sur la tension de précharge désirée (Vp) du bus (11).

7. Circuit selon la revendication 6, caractérisé en ce que les deux transistors montés en diodes du circuit de polarisation (13) sont montés en série entre les deux potentiels d'alimentation avec deux transistors à effet de champ de types complémentaires (N3, P3) commandés respectivement par les formes directe et complémentaire du signal d'horloge (φ).

## Patentansprüche

1. Vorladungsschaltung (10) eines Speicherbusses (11), die einen Transistor (Q) enthält, der durch ein Taktsignal (φ) gesteuert wird, der den Bus mit einem Versorgungspotential verbindet und dessen Steuerelektrode (B) über zwei entsprechende Feldeffekttransistoren des komplementären Typs (N2, P2), deren Gates mit dem Ausgang eines an den Bus angeschlossenen Schwellenwertverstärkers (12) verbunden sind, mit zwei Versorgungspotentialen verbunden ist, dadurch gekennzeichnet, daß der Transistor (Q) vom bipolaren Typ ist und durch das Taktsignal (φ) über einen dritten Feldeffekttransistor (P1) gesteuert wird, dessen Drain-Source-Pfad mit demjenigen eines (P2) der zwei Feldeffekttransistoren in Serie geschaltet ist.

2. Schaltung nach Anspruch 1, dadurch gekennzeichnet, daß der Schwellenwert (Ta) des Verstärkers (12) etwas kleiner als die gewünschte Vorladungsspannung (Vp) des Busses (11) ist.

3. Vorladungsschaltung nach Anspruch 1 oder 2, dadurch gekennzeichnet, daß das Taktsignal den Durchlaßzustand eines vierten Feldeffekttransistors (N1) steuert, dessen Drain-Source-Pfad zu demjenigen des anderen Transistors (N2) der beiden obenerwähnten Feldeffekttransistoren parallelgeschaltet ist.

4. Schaltung nach einem der Ansprüche 1 bis 3, dadurch gekennzeichnet, daß der Bus (11) an eine Vorspannungsschaltung (13) angeschlossen ist, die durch das Taktsignal gesteuert wird und auf die gewünschte Vorladungsspannung (Vp) des Busses (11) eingestellt ist.

5. Schaltung nach Anspruch 4, dadurch gekennzeichnet, daß die Vorspannungsschaltung (13) einen Spannungsteiler (N4, P4) enthält, der eine auf die gewünschte Vorladungsspannung (Vp) des Busses (11) eingestellte Vorspannung liefert.

6. Schaltung nach Anspruch 4 oder 5, dadurch gekennzeichnet, daß die Vorspannungsschaltung (13) zwei Feldeffekttransistoren des komplementären Typs (N4, P4) enthält, die als Dioden geschaltet und relativ zueinander so dimensioniert sind, daß die Vorspannung auf die gewünschte Vorladungsspannung (Vp) des Busses (11) eingestellt wird.

7. Schaltung nach Anspruch 6, dadurch gekennzeichnet, daß die zwei als Dioden geschalteten Transistoren der Vorspannungsschaltung (13) zwischen den zwei Versorgungspotentialen mit zwei Feldeffekttransistoren des komplementären Typs (N3, P3), die durch die direkte Form bzw. die komplementäre Form des Taktsignals (φ) gesteuert werden, in Serie geschaltet sind.

## Claims

1. A preloading circuit (10) for a memory bus (11), comprising a transistor (Q) controlled by a clock signal (φ) and linking the bus to a supply potential, the control electrode (B) of said transistor being linked to the two supply potentials via two respective field-effect transistors of complementary types (N2, P2) having their gates linked to the output of a threshold amplifier (12) connected to the bus, characterised in that said transistor (Q) is of bipolar type and is controlled by the clock signal (φ) via a third field-effect transistor (P1), the drain-source path of which is connected in series with that of one (P2) of the two field-effect transistors.

2. A circuit according to Claim 1, characterised in that the threshold value (Ta) of the amplifier (12) is slightly less than the desired preloading voltage (Vp) of the bus (11).

3. A preloading circuit according to Claim 1 or 2, characterised in that the clock signal controls the conduction of a fourth field-effect transistor (N1), the drain-source path of which is connected in parallel with that of the other transistor (N2) of the two aforementioned field-effect transistors.

4. A circuit according to one of Claims 1 to 3, characterised in that the bus (11) is connected to a polarisation circuit (13) controlled by the clock signal and adjusted to the desired preloading voltage (Vp) of the bus (11).

5. A circuit according to Claim 4, characterised in that the polarisation circuit (13) includes a voltage divider (N4, P4) supplying a polarisation voltage adjusted to the desired preloading voltage (Vp) of the bus (11).

6. A circuit according to Claim 4 or 5, characterised in that the polarisation circuit (13) includes two field-effect transistors of complementary types (N4, P4) connected as diodes and having dimensions relative to one another so as to adjust the polarisation voltage to the desired preloading voltage (Vp) of the bus (11).

7. A circuit according to Claim 6, characterised in that the two transistors connected as diodes of the polarisation circuit (13) are connected in series between the two supply potentials with two field-effect transistors of complementary types (N3, P3) controlled respectively by the direct and complementary forms of the clock signal (φ).
